Europäisches Patentamt

**European Patent Office**

Office européen des brevets

(19)

(11) **EP 0 772 054 B1**

(12) **EUROPÄISCHE PATENTSCHRIFT**

(45) Veröffentlichungstag und Bekanntmachung des Hinweises auf die Patenterteilung:
**23.04.2003 Patentblatt 2003/17**

(51) Int Cl.⁷: **G01R 31/28**, G01R 31/302

(21) Anmeldenummer: **96117642.7**

(22) Anmeldetag: **04.11.1996**

(54) **Verfahren und Vorrichtung zum Prüfen einer elektrischen Leiteranordnung**

Method and device for testing an electric conductor arrangement

Procédé et appareil pour tester des structures de conducteur

(84) Benannte Vertragsstaaten:
**DE FR GB IT**

(30) Priorität: **06.11.1995 DE 19541307**

(43) Veröffentlichungstag der Anmeldung:
**07.05.1997 Patentblatt 1997/19**

(73) Patentinhaber: **atg test systems GmbH & Co. KG 97877 Wertheim (DE)**

(72) Erfinder:
• **Ianenko, Evgueni**
 **97877 Wertheim-Dörlesberg (DE)**
• **Bieber, Peter**
 **97318 Kitzingen (DE)**

• **Rothaug, Uwe**
 **97828 Marktheidenfeld (DE)**

(74) Vertreter: **Ganahl, Bernhard Reinhardt-Söllner-Ganahl, P.O. Box 12 26 85542 Kirchheim b. München (DE)**

(56) Entgegenhaltungen:
**EP-A- 0 246 034    EP-A- 0 508 062
EP-A- 0 527 321    EP-A- 0 667 538
WO-A-94/08248    WO-A-95/08125
GB-A- 2 136 138    US-A- 3 975 680
US-A- 5 218 294**

**Beschreibung**

Die Erfindung betrifft ein Verfahren und eine Vorrichtung zum Prüfen einer elektrischen Leiteranordnung.

Derartige Leiteranordnungen sind im Allgemeinen in sogenannte Leiterplatten eingebettet und können eine Vielzahl von räumlich eng beieinander liegenden Leiterbahnen bzw. Netzen aufweisen. Nachfolgend wird für den Begriff "Leiterbahn" der in diesem Fachgebiet gebräuchliche Begriff "Netz" verwendet, wobei dies nicht bedeutet, daß das Netz Verzweigungsstellen aufweisen muß.

Aus der DE 34 08 704 A1 ist eine Vorrichtung zur Prüfung einer elektrischen Leiteranordnung bekannt, bei der die einzelnen Netze mittels einer Widerstands- und Kapazitätsmessung vermessen werden. Die ermittelten Meßwerte werden mit vorbestimmten Referenzwerten einer fehlerfreien Leiteranordnung verglichen. Aus Abweichungen der Meßwerte von den Referenzwerten können sowohl das Vorliegen eines Fehlers im Netz als auch die Art und der Ort des Fehlers bestimmt werden. Dieses Meßverfahren hat sich in der Praxis bewährt, da es einfach und schnell durchführbar ist und eine zuverlässige Fehlererkennung ermöglicht.

Bei diesem Meßverfahren ist jedoch die Ermittlung der Referenzwerte ein aufwendiger Vorgang. Die Referenzwerte können durch entsprechende Widerstands- und Kapazitätsmessungen an einer fehlerfreien Leiteranordnung, einem sogenannten "Golden Board" ermittelt werden. Die Herstellung eines "Golden Board" ist aufwendig und teuer und läßt sich bei modernen Leiterplatten mit einer hohen Netzdichte nicht realisieren.

Deshalb hat man Lernverfahren entwickelt, bei welchen mehrere identische Leiteranordnungen vermessen und die Meßwerte bestimmter Leiterbahnen miteinander verglichen werden. Um hier zuverlässige Referenzwerte zu erhalten, sind eine Vielzahl von Messungen und aufwendige statistische Auswerteverfahren notwendig.

Aufgrund dieses hohen technischen Aufwandes beim Lernverfahren hat man auch versucht, die Referenzwerte aus den Konstruktionsunterlagen zu berechnen. Derartige Berechnungen erfordern jedoch auch einen beträchtlichen Rechenaufwand, und bei systematischen, fertigungsbedingten Abweichungen weichen die berechneten Referenzwerte von den tatsächlichen Referenzwerten ab.

In der EP 0 508 062 B1 ist ein Verfahren zur Prüfung elektrischer Leiteranordnungen beschrieben, bei dem jedes Netz bezüglich einer vorbestimmten Anzahl von Antennen vermessen wird. Als Antennen können externe längliche Elektroden verwendet werden, die an der Oberfläche einer die Leiteranordnung enthaltenden Leiterplatte angeordnet werden. Es ist auch möglich, bestimmte Netze der Leiteranordnung bezüglich anderer Netze als Antennen zu verwenden, so daß keine zusätzlichen externen Antennen vorgesehen werden müssen.

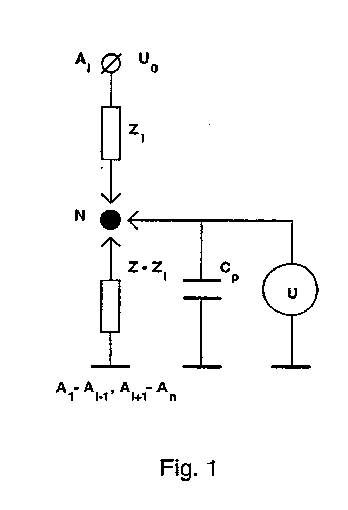

In Fig. 1 ist schematisch eine solche Meßanordnung mit n Antennen $A_1$-$A_n$ und dem zu messenden Netz N dargestellt. Bei einem Meßvorgang wird an eine der Antennen $A_i$ eine komplexe Eingangsspannung $U_0$ angelegt, und die übrigen Antennen $A_1$-$A_{i-1}$ und $A_{i+1}$-$A_n$ sind mit Masse verbunden. Zwischen dem Netz N und der Antenne $A_i$ besteht der komplexe Widerstand (= Impedanz) $Z_i=Z_{iR}+iZ_{il}$, und zwischen den übrigen Antennen und dem Netz N der komplexe Widerstand $Z-Z_i$, wobei Z der komplexe Gesamtwiderstand zwischen allen Antennen und dem Netz N ist. Am Netz N wird mit einer Sonde, die die Kapazität $C_p$ aufweist, die komplexe Spannung $U_i=U_{iR}+iU_{il}$ abgegriffen.

Die komplexe Eingangsspannung $U_0=U_{0R}+iU_{0l}$ ist aus einem konstanten Gleichspannungsanteil und einem Wechselspannungsanteil mit einer bestimmten Frequenz $2\pi\omega$ zusammengesetzt. Diese Eingangsspannung $U_0$ wird jeweils an eine der Antennen angelegt, wobei jedes mal der Meßwert $U_i$ am Netz N abgegriffen wird. Der Satz von Meßwerten $U_1$-$U_n$ bildet ein Datenfeld, dessen Werte einen für das Netz N typischen "Fingerabdruck" darstellen. Dieses Meßverfahren wird als Feldmessung bezeichnet.

Die Datenfelder der einzelnen Netze unterscheiden sich in der Regel. Sollten die Datenfelder zweier Netze jedoch gleich sein, beruht dies in der Regel auf einem Kurzschluß zwischen diesen beiden Netzen. Dies kann mit einem herkömmlichen Kurzschlußtest überprüft werden, bei dem der elektrische Widerstand zwischen diesen beiden Netzen gemessen wird. Diese Kurzschlußtests müssen nur bei Netzen mit identischen Datenfeldern durchgeführt werden, so daß der Meßaufwand im Vergleich zu ähnlichen Meßverfahren sehr gering ist. Die Überprüfung auf Unterbrechungen kann in bekannter Art und Weise durch eine Widerstandsmessung, bei der Elektroden an den Enden des Netzes den Widerstand abgreifen, oder durch Vergleichen des Datenfeldes mit einem Referenzfeld erfolgen.

Wird eine Feldmessung zur Ermittlung der Kurzschlüsse zwischen den einzelnen Netzen in Kombination mit einer Widerstandsmessung zur Ermittlung von Unterbrechungen an den einzelnen Netzen verwendet, so werden keine Referenzwerte bzw. Referenzfelder benötigt. Dies vereinfacht das Meßverfahren wesentlich, da kein "Golden Board" und keine Verfahren zur Ermittlung von Referenzwerten benötigt werden. Da jedoch beim Vermessen einer jeden Leiterbahnanordnung Widerstandsmessungen an jedem Netz zur Ermittlung von Unterbrechungen durchzuführen sind, ist dieses Meßverfahren relativ langwierig.

Durch die Verwendung von Referenzfeldern können mit der Feldmessung sowohl Kurzschlüsse als auch Unterbrechungen festgestellt werden, wodurch das Meßverfahren beträchtlich beschleunigt wird. Es besteht jedoch wiederum die Eingangs erwähnte Problematik der Ermittlung von Referenzwerten bzw. der Ermittlung von Referenzfeldern.

Der Erfindung liegt die Aufgabe zugrunde, ein einfach und schnell ausführbares Verfahren zur Prüfung einer elektrischen Leiteranordnung und eine Vorrichtung zur Ausführung dieses Verfahrens zu schaffen.

Die Aufgabe wird durch ein Verfahren mit den Merkmalen des Anspruchs 1 und durch eine Vorrichtung mit den Merkmalen des Anspruchs 20 gelöst.

Mit dem erfindungsgemäßen Verfahren wird in einem ersten Meßvorgang mittels einer Feldmessung zur Ermittlung von Kurzschlüssen zwischen einzelnen Netzen und mittels einer Widerstandsmessung zur Ermittelung von Unterbrechungen an den einzelnen Netzen eine erste Leiteranordnung vermessen. Aus den hierbei ermittelten Datenfeldern werden Leitwerte zwischen den einzelnen Netzen und den entsprechenden Antennen bestimmt und als Referenzleitwerte abgespeichert.

In den nachfolgenden Meßvorgängen wird zur Ermittlung von Kurzschlüssen eine Messung des komplexen Leitwertes zwischen jedem zu messenden Netz und jeweils einer einzigen Antenne durchgeführt, wobei der ermittelte komplexe Ist-Leitwert mit dem entsprechenden Referenzleitwert verglichen wird. Zur Ermittlung der Unterbrechungen kann der Vergleich zwischen dem Leitwert und dem Referenzleitwert herangezogen werden, wobei durch Berücksichtigung des Realteils des Ist-Leitwerts hochohmige Kurzschlüsse zwischen den Netzen und Unterbrechungen in den Netzen detektiert werden können.

Vorteilhafte Ausgestaltungen der Erfindung sind in den Unteransprüchen gekennzeichnet.

Die Erfindung wird nachfolgend beispielhaft anhand der Zeichnungen näher beschrieben. Es zeigen:

Fig. 1    schematisch ein Ersatzschaltbild einer Meßanordnung,
Fig. 2    schematisch einen Ausschnitt aus einer Leiteranordnung,
Fig. 3    schematisch ein Ersatzschaltbild einer weiteren Meßanordnung,
Fig. 4    schematisch ein Multi-Finger-System zum Abtasten einer Leiteranordnung.

Das erfindungsgemäße Verfahren ist in einen ersten Meßvorgang zum Prüfen einer ersten Leiteranordnung und in nachfolgende Meßvorgänge zum Prüfen jeweils einer weiteren Leiteranordnung untergliedert. Der **erste Meßvorgang** umfaßt eine Feldmessung zur Ermittlung der Kurzschlüsse zwischen Netzen und eine Widerstandsmessung zur Ermittlung von Unterbrechungen.

In Fig. 1 ist schematisch eine Meßanordnung für die Feldmessung dargestellt. Diese Meßanordnung weist $n$ Antennen $A_1$-$A_n$ auf, mit welchen ein Netz $N$ vermessen wird. Bei einem Meßvorgang wird an eine der Antennen $A_i$ eine komplexe Eingangsspannung $U_0$ angelegt, und die übrigen Antennen $A_1$-$A_{i-1}$ und $A_{i+1}$-$A_n$ sind mit Masse verbunden. Zwischen dem Netz $N$ und der Antenne $A_i$ besteht der komplexe Leitwert $Y_i=Y_{iR}+iY_{il}=1/Z_i$, und zwischen dem Netz $N$ und den übrigen Antennen der komplexe Leitwert $Y-Y_i=1/(Z-Z_i)$, wobei $Y=Y_R+iY_l$ der komplexe Gesamtleitwert zwischen allen Antennen und dem Netz $N$ ist. Am Netz $N$ wird mit einer Sonde, die die Kapazität $C_p$ aufweist, die komplexe Spannung $U_i=U_{iR}+iU_{il}$ abgegriffen.

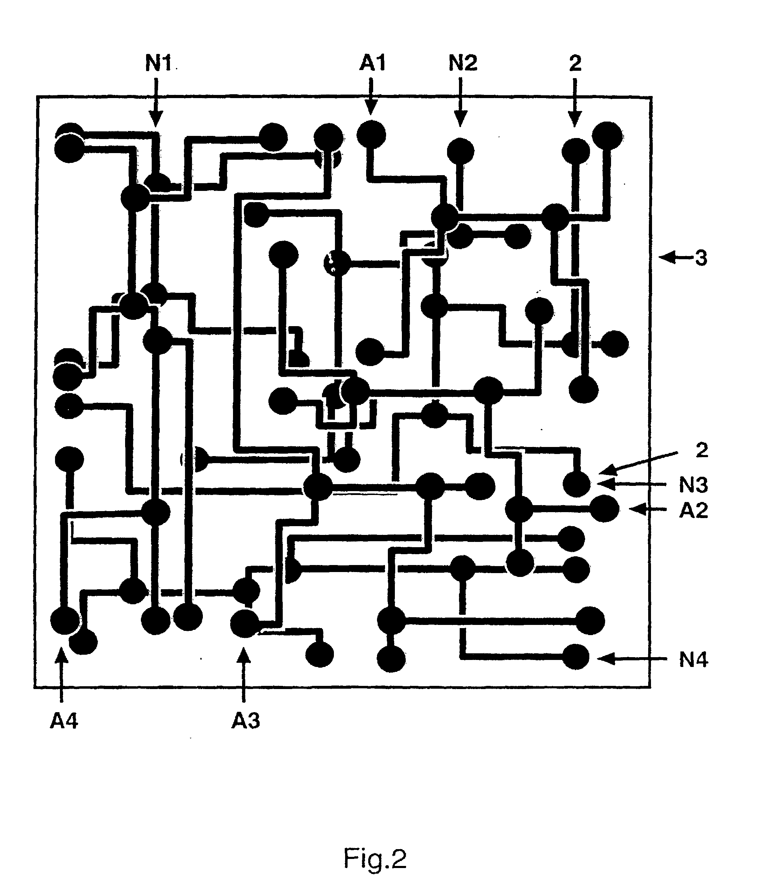

Fig. 2 zeigt schematisch einen Ausschnitt einer Leiteranordnung, wobei vier Netze als Antennen $A_1$-$A_4$ zum Prüfen der weiteren Netze $N_1$-$N_4$ verwendet werden. Statt interne Netze der Leiteranordnung als Antennen zu benutzen, können auch externe Antennen verwendet werden.

Die komplexe Eingangsspannung $U_0=U_{0R}+iU_{0l}$ ist vorzugsweise eine Sinuswelle mit einer bestimmten Frequenz (bspw. $2\pi\omega = 2$ kHz), wobei die Amplitude im Bereich von 4 V bis 250 V liegt. Diese Eingangsspannung $U_0$ wird jeweils an eine der Antennen $A_i$ angelegt, wobei jedesmal eine Spannung $U_i$ als Meßwert am Netz $N$ abgegriffen wird. Die Spannung $U_i$ ist das Potential des elektrischen Feldes zwischen der Antenne $A$, an der die Eingangsspannung $U_0$ anliegt, und den mit Masse verbundenen Antennen. Mit dieser Spannungsmessung wird somit ein elektrisches Feld abgegriffen, weshalb dieses Verfahren als Feldmessung bezeichnet wird. Der Satz von Meßwerten $U_1$ bis $U_n$ bildet das für das Netz $N$ charakteristische Datenfeld.

Die Datenfelder der einzelnen Netze $N_i$ unterscheiden sich in der Regel. Stimmen die Datenfelder zweier Netze überein, so beruht dies meistens auf einem Kurzschluß zwischen diesen beiden Netzen. Dies kann mit einem herkömmlichen Kurzschlußtest überprüft werden, bei dem der Widerstand zwischen diesen beiden Netzen gemessen wird. Diese Kurzschlußtests werden nur bei Netzen mit identischen oder innerhalb gewisser Grenzen ähnlichen Datenfeldern durchgeführt, so daß der Meßaufwand im Vergleich zu herkömmlichen Meßverfahren sehr gering ist.

Die Überprüfung auf Unterbrechungen wird durch eine Widerstandsmessung ausgeführt, bei der Elektroden an den Enden des Netzes den Widerstand abgreifen.

Durch das kombinierte Meßverfahren mit Feld- und Widerstandsmessung im ersten Meßvorgang ist man unabhängig von einem "Golden Board" bzw. vorbereiteten Referenzdaten.

Aus dem ersten Meßvorgang erhält man bei $n$ Antennen für jedes Netz ein Datenfeld mit den komplexen Spannungen $U_1$ bis $U_n$. Ferner sind die komplexe Eingangsspannung $U_0$ und die Kapazität $C_p$ der Sonde bekannt.

Der Erfindung liegt die Erkenntnis zugrunde, daß man aus diesen Daten den komplexen Leitwert (=1/Impedanz) $Y_i=Y_{iR}+iY_{il}=1/Z_i$ bestimmen kann. So gilt

$$Y_{il} = \frac{U_{iR}*X_I + U_{il}*Y_R}{U_0} \tag{1}$$

$$Y_{iR} = \frac{U_{iR}*Y_R - U_{il}*X_I}{U_0} \tag{2}$$

wobei

$$X_i = Y_i + \omega * C_p \tag{3}$$

Der Realteil und der Imaginärteil des Gesamtleitwertes Y bestimmen sich zu

$$Y_I = \frac{\sum U_{iR}*(U_0 - \sum U_{iR}) - (\sum U_{il})^2}{(U_0 - \sum U_{iR})^2 + (\sum U_{il})^2} * \omega * C_p \tag{4}$$

$$Y_R = \frac{-U_0 * \sum U_{il}}{(U_0 - \sum U_{iR})^2 + (\sum U_{il})^2} * \omega * C_p \tag{5}$$

wobei die Summenzeichen jeweils eine Summe von 1 bis n eines Datenfeldes eines Netzes darstellen. Nach der Berechnung des komplexen Leitwertes wird geprüft, ob der Realteil des Leitwertes $Y_R$ gleich Null ist ($Y_R = 0$ ?), denn ein Realteil des Leitwertes der ungleich Null ist ($Y_R \neq 0$) bedeutet, daß am gemessenen Netz N ein hochohmiger Kurzschluß vorliegt. Ist der Realteil des Leitwertes $Y_R$ gleich Null, so wird der Imaginärteil des Leitwertes $Y_I$ als Referenzwert abgespeichert, wobei der Imaginärteil des Leitwertes die Kapazität $C_{ia}$ zwischen der Antenne $A_i$ und dem Netz N darstellt ($Y_I = C_{ia}$).

Es hat sich gezeigt, daß die Leitwerte aus den mit der Feldmessung erhaltenen Daten mit einer Genauigkeit von besser als 1,5% ermittelt werden können, so daß sie als Referenzwerte für ein mit einem Leitwertvergleich arbeitendes Meßverfahren geeignet sind.

Beim ersten Meßvorgang werden deshalb gleichzeitig mit der Prüfung einer Leiteranordnung auch die komplexen Leitwerte $Y_i$ zwischen den Netzen und den Antennen $A_i$ berechnet. Die Leitwerte $Y_i$ bzw. die Kapazitäten $C_{ia}$ werden als Referenzwerte für die nachfolgenden Meßvorgänge abgespeichert.

Es ist auch möglich, anstatt dem Leitwert $Y_i$ bzw. der Kapazität $C_{ia}$ zwischen dem Netz $N_k$ und einer einzigen Antenne $A_i$ einen Gesamtleitwert $Y_{kG}$ bzw. eine Gesamtkapazität $C_{aG}$, die zwischen dem Netz $N_k$ und mehreren miteinander elektrisch verbundenen Antennen $A_i$ besteht, aus den Felddaten zu berechnen. Dies ist zweckmäßig, wenn bei den weiteren Meßvorgängen eine Antenne verwendet wird, die aus mehreren miteinander elektrisch kurzgeschlossenen Antennen $A_i$ besteht. Es ist auch möglich, die Datenfelder der Feldmessung abzuspeichern und bei jedem weiteren Meßvorgang die entsprechenden Kapazitäten zu berechnen, so daß die Anordnung der Antennen variiert werden kann.

Die **weiteren Meßvorgänge** werden durch eine Leitwertmessung der Leitwerte $Y_k$ zwischen den Netzen $N_k$ und jeweils einer der Antennen $A_i$ ausgeführt. Diese Ist-Leitwerte $Y_k$ werden mit den entsprechenden Referenzwerten verglichen, wobei bei Abweichungen untersucht wird, ob ein Kurzschluß mit einem anderen Netz oder eine Unterbrechung im Netz oder beides vorliegt.

Die Bestimmung eines Kurzschlusses kann ähnlich wie bei dem aus dem Stand der Technik (z.B. DE 34 08 704 A1 oder EP 0 438 491 B1) bekannten Impedanzvergleich erfolgen. Hierbei wird die Kapazität bzw. die Impedanz des Netzes gemessen, und bei Abweichungen vom Referenzwert wird eine konventionelle Widerstandsmessung durchgeführt, um den Kurzschluß zu lokalisieren.

Nachteilig an diesen bekannten mit einem Impedanzvergleich arbeitenden Verfahren ist, daß hochohmige Kurzschlüsse aus dem Impedanzvergleich nicht feststellbar sind. Diese hochohmigen Kurzschlüsse können deshalb nur bei einer visuellen Kontrolle der Leiteranordnung festgestellt werden, die nach einem auf einem Impedanzvergleich beruhenden Meßverfahren unbedingt notwendig ist.

Die Erfindung sieht deshalb vorzugsweise für die nachfolgenden weiteren Meßvorgänge einen modifizierten Vergleich des gemessenen Leitwertes $Y_i$ mit den Referenzwerten zur **Bestimmung von Kurzschlüssen** vor. Bei den weiteren Meßvorgängen wird eine einfache und schnell ausführbare Messung des Leitwertes $Y_k$ vorgesehen, um Kurz-

schlüsse an den Netzen $N_k$ festzustellen, wobei der Leitwert $Y_k$ der Leitwert zwischen dem Netz $N_k$ und der jeweiligen Antenne $A_i$ ist. Im Vergleich zur Feldmessung vermindert sich der Meßaufwand deutlich, da keine Mehrfachabtastung eines Netzes $N_k$ durch mehrere Antennen $A_i$ notwendig ist. Die weiteren Meßvorgänge zur Ermittlung von Kurzschlüssen zwischen den einzelnen Netzen $N_k$ beruhen somit auf der einfach und schnell durchführbaren Messung des Leitwertes $Y_k$, wobei auch hochohmige Kurzschlüsse festgestellt werden können. Wird ein Kurzschluß an einem Netz festgestellt, dann wird er in bekannter Art und Weise mit einer Widerstandsmessung lokalisiert.

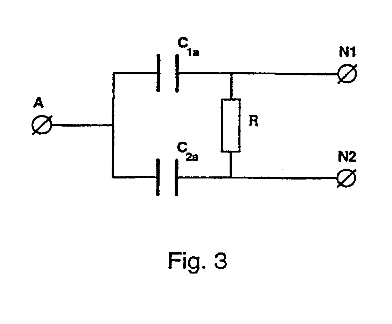

Der erfindungsgemäße Meßvorgang zur Ermittlung, ob zwischen einem Netz $N_1$ und einem beliebigen anderen Netz $N_2$ ein Kurzschluß besteht, wird nachfolgend anhand des in Fig. 3 dargestellten Ersatzschaltbildes erläutert. Hierbei wird vom Leitwert $Y_1$ zwischen der Antenne A und dem Netz $N_1$ ausgegangen, wobei $C_{1a}$ und $C_{2a}$ die jeweiligen Kapazitäten (=Referenzwerte) zwischen der Antenne A und den Netzen $N_1$ und $N_2$, und R den Widerstand (=unbekannte Größe) zwischen den beiden Netzen darstellen. Für den komplexen Leitwert gilt:

$$Y_{1R}+iY_{1I}=i\omega*C_{1a}+\frac{i\omega*C_{2a}*\frac{1}{R}}{i\omega*C_{2a}+\frac{1}{R}} \tag{6}$$

Durch eine geschickte Umformung ergibt sich:

$$(Y_{1R})^2+(Y_{1I}-\omega*C_{1a})^2=\frac{1}{R^2+(\frac{1}{\omega*C_{2a}})^2} \tag{7}$$

Berücksichtigt man die Meßabweichungen $\Delta_Y$ für den gemessenen Leitwert $Y_1$, die maximale Abweichung $\Delta_C$ zwischen den Kapazitäten der gleichen Netze unterschiedlicher Leiteranordnungen, und setzt man für den Widerstand R einen Schwellenwert $R_{TK}$ ein und wählt man $C_{2a} \geq C_{1a}$, so kann man obige Gleichung in folgende Ungleichung umformen:

$$(abs(Y_{1R})+\Delta_Y)^2+(abs(Y_{1I}-\omega*C_{1a})+\Delta_Y+\Delta_C)^2\leq\frac{1}{R_{TK}^2+(\frac{1}{\omega*C_{1a}})^2} \tag{8}$$

Die Werte $\Delta_Y$ und $\Delta_C$ sind Erfahrungswerte, die von der verwendeten Meßvorrichtung und der Art der Leiteranordnung abhängen.

Die Bedingung $C_{2a} \geq C_{1a}$ läßt sich einfach durch Austausch der entsprechenden Netze N erfüllen.

Ist der tatsächliche Widerstand R zwischen dem Netz $N_1$ und allen anderen Netzen $N_k$ größer als der Schwellenwert $R_{TK}$, so ist obige Ungleichung (8) erfüllt, und es steht fest, daß vom Netz $N_1$ kein Kurzschluß zu einem größeren Netz bzw. einem Netz mit größerer Kapazität besteht.

Bei den üblichen Frequenzen (z.B.: $2\pi\omega$ = 2 kHz) gilt für Netze mit kleiner Kapazität $C_{1a}$ für Schwellenwerte $R_{TK}$ bis zu 10 MΩ

$$R_{TK}^2 << (\frac{1}{\omega*C_{1a}})^2, \tag{9}$$

so daß obige Ungleichung (8) zu

$$(abs(Y_{1R})+\Delta_Y)^2+(abs(Y_{1I}-\omega*C_{1a})+\Delta_Y+\Delta_C)^2\leq(\omega*C_{1a})^2 \tag{10}$$

vereinfacht werden kann. Diese Ungleichung (10) ist für kleine Netze erfüllt, so daß die Ungleichung (8) auch bei kleinen Netzen als Kriterium für Kurzschlüsse angewandt werden kann. Somit ist es durch den erfindungsgemäßen Vergleich, in den auch der Realteil des Leitwertes $Y_R$ einfließt, möglich, hochohmige Kurzschlüsse an Netzen mit kleiner Kapazität festzustellen.

Unterbrechungen in den Netzen $N_k$ können in den weiteren Meßvorgängen entweder durch eine an sich bekannte Widerstandsmessung oder durch einen Vergleich des Ist-Leitwertes $Y_k$ bzw. der Ist-Kapazität $C_k$ mit den

abgespeicherten Referenzwerten erfolgen.

Die zu untersuchenden Netze haben oft L=20.000 oder mehr Prüfpunkte. Greift man alle Prüfpunkte paarweise für einen Unterbrechungstest mittels Widerstandsmessung ab, so sind L-1 Messungen pro Netz notwendig. Hierbei werden die Prüfpunkte jeweils paarweise abgegriffen, wobei zur Optimierung der Anzahl der Messungen nur bestimmte Paare von Prüfpunkten abgegriffen werden können, so daß Meßfinger, die die Prüfpunkte abgreifen, nur in einer vorbestimmten Art und Weise paarweise bewegt werden. Um den Meßvorgang zu vereinfachen, ist es auch bekannt, Unterbrechungen mittels eines Kapazitätsvergleichs zu ermitteln (US 3,975,680). Hierbei wird jeder Prüfpunkt einmal mit einem Meßfinger kontaktiert, wobei die Prüfpunkte in beliebiger Reihenfolge abgegriffen werden, so daß sich die Bewegungen der Meßfinger wesentlich vereinfachen.

Erfindungsgemäß wird deshalb vorgeschlagen, den an den Prüfpunkten gemessenen Leitwert $Y_i$ mit dem entsprechenden Referenzwert zu vergleichen, wobei dieses Verfahren nur an ausreichend großen Netzen mit einer ausreichend hohen Kapazität durchgeführt wird.

Das erfindungsgemäße Meßverfahren zur Ermittlung von Unterbrechungen wird wiederum an dem in Fig. 3 dargestellten Ersatzschaltbild erläutert, wobei angenommen wird, daß das zu untersuchende Netz in zwei Teilnetze $N_1$ und $N_2$ unterteilt ist, die durch die zu ermittelnde Unterbrechung mit dem Widerstand R voneinander getrennt sind. Für die als Referenzwert abgespeicherte Gesamtkapazität gilt $C=C_{1a}+C_{2a}$, wobei $C_{1a}$ und $C_{2a}$ die Kapazitäten der Teilnetze $N_1$ und $N_2$ sind.

Für den am Teilnetz $N_1$ gemessenen Leitwert $Y_1$ gilt:

so daß aus (11) für den am Teilnetz $N_1$ gemessenen Leitwert abgeleitet werden kann:

$$Y_{1R}+iY_{1I}= i\omega C_{1a} + \frac{R+\dfrac{i}{\omega C_{2a}}}{R^2+(\dfrac{1}{\omega C_{2a}})^2} \tag{11}$$

$$Y_{1I}=\omega C_{2a}\frac{1}{1+\omega^2*C_{2a}^2*R^2} \tag{12}$$

$$Y_{1R}=\frac{1}{R}*\frac{\omega^2*C_{2a}^2*R^2}{1+\omega^2*C_{2a}^2*R^2} \tag{13}$$

Die Differenz des gemessenen Leitwertes zu dem Referenzwert ist:

$$\omega C - Y_{1I}= \omega C_{2a}\frac{\omega^2*C_{2a}^2*R^2}{1+\omega^2*C_{2a}^2*R^2} \tag{14}$$

$$Y_{1R}-0= \frac{1}{R}*\frac{\omega^2*C_{2a}^2*R^2}{1+\omega^2*C_{2a}^2*R^2} \tag{15}$$

Vergleicht man die Werte des Imaginär- und des Realteils in

$$\frac{\omega*C-Y_{1I}}{Y_{1R}}= \omega*C_{2a}*R, \tag{16}$$

so zeigt sich, daß für einen gegebenen Schwellenwert für Unterbrechungen $R_{TU}$ und für kleine Werte von $C_{2a}$ eine Änderung des Realteils des Leitwertes $Y_{1R}$ eine größere Abweichung bewirkt als eine Änderung am Imaginärteil. Der Realteil des Leitwertes ist somit sensitiver als der Imaginärteil. Um abzuschätzen, welche Netze mittels eines Leitwertvergleiches auf Unterbrechungen untersucht werden können, führt man die Genauigkeit der Leitwertmessung $\delta=\Delta_Y/Y$ und als skalare Größe $\alpha=\omega C_{2a}R\leq1$ ein. Für das zu untersuchende Teilnetz gilt ferner $C_{1a}\leq C_{2a}$, $C_{1a}\leq C/2$ und $C_{2a}\geq C/2$.

Der Realteil kann wahrgenommen werden, wenn gemäß (15)

$$Y_{1R} \frac{\omega * C_{2a}}{\alpha} * \frac{\alpha^2}{1+\alpha^2} \geq \frac{\omega * C_{2a} * \alpha}{2} \geq \frac{R_{TU} * \omega^2 * C^2}{8}$$

größer ist als

$$\frac{\delta * \omega * C}{2} > \delta * \omega * C_{1a} = \Delta_Z$$

Für das Kriterium, ob ein Netz mit einem Leitwertvergleich auf Unterbrechungen untersucht werden kann, ergibt sich somit:

$$C > \frac{4 * \delta}{\omega * R_{TU}} \qquad (17)$$

Für typische Werte von $R_{TU}$=1 kΩ, δ=0,3% und ω=2π*2.000 1/s ergibt sich eine Mindestkapazität von etwa 1nF. Solche Kapazitäten werden im Allgemeinen von größeren Leiterbahnanordnungen mit einigen Hundert oder mehr Prüfpunkten erreicht.

Für die Erstellung der Prüfkriterien wird davon ausgegenagen, daß α≤1 und somit ωC-$Y_{1l}$≤(ω$C_{2a}$)/2<(ωC)/4 gilt. Berücksichtigt man noch die Meßgenauigkeit $\Delta_Y$ und die maximale Abweichung der Kapazität $\Delta_c$ zwischen gleichen Netzen unterschiedlicher Leiteranordnungen, so ergibt sich als Kriterium, ob eine Unterbrechung vorliegt:

$$\omega * C - Y_{1l} + \Delta_Y + \Delta_C < \frac{\omega * C}{4} \qquad (18)$$

und

$$Y_{1R} + \Delta_Y < \frac{R_{TU} * \omega^2 * C^2}{8} \qquad (19)$$

Sind die beiden Ungleichungen (18) und (19) erfüllt, so liegt keine Unterbrechung vor. Die Unterbrechung kann mit einer an sich bekannten Widerstandsmessung lokalisiert werden.

Das Meßverfahren für die weiteren Meßvorgänge kann somit für ausreichend große Netze, die die Ungleichung (17) erfüllen, folgendermaßen zusammengefaßt werden:

1.) An allen Prüfpunkten wird der Leitwert $Y_k$ gemessen.

2.) Falls alle Leitwerte identisch sind und mit dem Referenzwert übereinstimmen, dann weist das Netz weder einen Kurzschluß noch eine Unterbrechung auf.

3.) Weicht ein Leitwert vom Referenzwert ab, so wird er den Prüfkriterien gemäß der Ungleichung (8) zum Feststellen von Kurzschlüssen bzw. gemäß den Ungleichungen (18) und (19) zum Feststellen von Unterbrechungen zugeführt, so daß die Art des Fehlers bestimmt wird.

4.) Ein festgestellter Kurzschluß bzw. eine festgestellte Unterbrechung kann dann in an sich bekannter Art und Weise mit einer Widerstandsmessung lokalisiert werden.

Bei kleineren Netzen, die nicht die Ungleichung (17) erfüllen, wird vorzugsweise folgendes Meßverfahren durchgeführt:

1.) An dem zu untersuchendem Netz $N_k$ wird ein Leitwert $Y_k$ gemessen.

2.) Falls der Leitwert vom Referenzwert abweicht, wird er dem Prüfkriterium nach der Ungleichung (8) zugeführt, und falls ein Kurzschluß festgestellt wird, wird der Kurzschluß mit einer Widerstandsmessung lokalisiert.

3.) Unterbrechungen werden in an sich bekannter Weise durch Widerstandsmessungen ermittelt, wobei alle Prüfpunkte paarweise abgegriffen werden.

Für diese Art der Ermittlung von Kurzschlüssen und Unterbrechungen ist es notwendig, daß Referenzkapazitäten vorliegen. Diese müssen selbstverständlich nicht durch eine Feldmessung bestimmt werden, sondern können auch mit den zur Bestimmung von Referenzimpedanzen bekannten Verfahren ermittelt werden.

Sollten beim ersten Meßvorgang eines oder mehrere Netze defekt sein, so wird unterschieden, ob mehr oder weniger als eine vorbestimmte Anzahl g Netze defekt sind. Sind mehr als die vorbestimmte Anzahl g von Netzen defekt, so wird mit einer weiteren Leiteranordnung die Feldmessung wiederholt, wobei die fehlenden Referenzwerte durch die neuen Messungen an nicht defekten Netzen ergänzt werden. Sind weniger als die vorbestimmte Anzahl von Netzen defekt, so wird ein weiterer Meßvorgang ausgeführt, bei dem der komplexe Leitwert $Y_k$ gemessen wird, wobei durch Widerstandsmessungen am Netz bzw. zwischen den Netzen oder durch einen Vergleich des Imaginärteils $Y_{kI}$ bzw. der Kapazität $C_{ka}$ des beim ersten Meßvorgang defekten Netzes mit den Kapazitäten der übrigen Netze und einer eventuell auszuführenden Widerstandsmessung zwischen Netzen gleicher Kapazität festgestellt werden kann, ob am gleichen Netz wiederum ein Defekt vorliegt. Ist das Netz nicht defekt, so wird der gemessene Leitwert $Y_k$ bzw. die gemessene Kapazität $C_{ka}$ als Referenzwert abgespeichert.

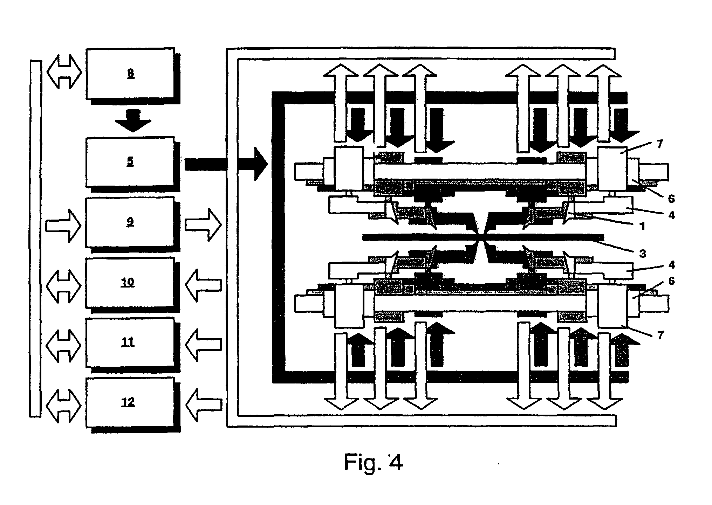

Eine **Vorrichtung** zur Ausführung des Verfahrens weist mehrere Elektroden 1 auf, die mit Prüfpunkten 2 der Netze $N_k$ auf einer Leiteranordnung 3 kontaktiert werden können (Fig. 2,4). Die Elektroden 1 sind vorzugsweise als Antennensonden und als Meßsonden verwendbar. Als Antennensonden legen sie an die mit ihnen verbundenen Netze entweder die Eingangsspannung $U_0$ oder Masse an, so daß die mit ihnen verbundenen Netze als Antennen wirken. Die Meßsonde greift die an dem mit ihr verbundenen Netz anliegende Spannung $U_i$ ab.

Eine bevorzugte Ausführungsform der Meßvorrichtung ist ein sogenanntes an sich bekanntes Multi-Finger-System (Fig. 4), bei dem jeweils eine Elektrode 1 in einen Meßfinger 4 integriert ist. Ein Multi-Finger-System, bei dem die Meßfinger unabhängig voneinander verfahrbar sind, ist in der EP 0 468 153 A1 beschrieben. Die Meßfinger 4 können parallel zur Oberfläche der Leiteranordnung 3 verschoben werden, so daß die Elektroden mit bestimmten Prüfpunkten 2 der Netze $N_k$ kontaktiert werden können. Ein solches Multi-Finger-System weist bspw. 16 Meßfinger 4 auf, wobei acht oberhalb und acht unterhalb der Leiteranordnung 3 angeordnet sind, um die Leiteranordnung 3 von beiden Seiten zu kontaktieren. Die Meßfinger 4 sind jeweils an einem durch eine Positionssteuereinrichtung 5 gesteuerten Schlitten 6 befestigt, der in einer Ebene parallel zur Leiteranordnung 3 verfahren werden kann. Die Schlitten 6 sind jeweils mit einem vertikal ausgerichteten Stellzylinder 7 versehen, mit dem die Meßfinger 4 um die vertikale Achse gedreht werden können. Ferner ist in den Meßfingern 4 eine Kippeinrichtung integriert, so daß der Finger mit der an seiner Spitze angeordneten Sonde 1 auf die Leiteranordnung 3 abgesenkt werden kann.

Beim ersten Meßvorgang werden eine Feldmessung und eine Widerstandsmessung durchgeführt. Für die Feldmessung wird die Leiteranordnung 3 in bestimmte Segmente unterteilt, wobei für jedes Segment bestimmte Netze dieses Segments als Antennen ausgewählt werden. Die als Antennen ausgewählten Netze sind während des Vermessens dieses Segments jeweils mit einer der Elektroden 1 in Kontakt, wobei die anderen Elektroden 1 abwechselnd jeweils ein Netz des Segments zur Aufnahme der Meßspannung $U_i$ kontaktieren. Das zu messende Netz wird gleichzeitig an zumindest einem weiteren Prüfpunkt 2 mit einer weiteren Elektrode 1 kontaktiert, so daß der Widerstandswert des Netzes zwischen den beiden Elektroden 1 abgegriffen werden kann. Mit der Widerstandsmessung werden die Netze auf Unterbrechungen überprüft, wobei alle Prüfpunkte an einem Netz paarweise abgegriffen werden.

Die Positionssteuereinrichtung 5 erhält zur Steuerung der Bewegung der Meßfinger 4 ihre Signale von einer zentralen Steuereinheit 8. Bei der Feldmessung werden durch die zentrale Steuereinheit 8 eine Antenne des Segments mit einem Funktionsgenerator 9, der die Meßspannung $U_0$ abgibt, und die anderen Antennen mit Masse in Verbindung gesetzt. Ferner stellt die zentrale Steuereinheit eine Verbindung des zu vermessenden Netzes $N_k$ über eine einzige Elektrode 1 zu einer ersten Auswerteeinrichtung 10 für die Feldmessung her, wobei die Spannung $U_i$ am Netz N abgegriffen wird. Weitere Netze $N_k$ können im Bereich eines Segments abgetastet werden, ohne daß hierzu die mit den Antennen in Verbindung stehenden Elektroden 1, sondern nur die Elektroden 1 zur Kontaktierung der zu messenden Netze bewegt werden.

Für die Widerstandsmessung werden alle Prüfpunkte 2 des Netzes $N_k$ jeweils mit einer Elektrode 1 paarweise in Verbindung gebracht. Der Widerstandswert dieses Netzes wird von einer zweiten Auswerteeinrichtung 11 aufgenommen und zu der zentralen Steuereinheit weitergeleitet.

Im ersten Meßvorgang werden somit die mit den Antennen in Verbindung stehenden Elektroden 1 nicht bewegt, und die anderen Elektroden 1 mit den zu messenden Netzen kontaktiert.

Die erste Auswerteeinrichtung 10 nimmt die abgegriffenen Spannungen $U_i$ (Feldmessung) auf und leitet sie zur zentralen Steuereinheit weiter, die die Referenzleitwerte ermittelt und abspeichert. Bei den weiteren Meßvorgängen wird bei ausreichend großen Netzen, die die Ungleichung (17) erfüllen, an jedem Prüfpunkt 2 als Leitwert $Y_k$ nur ein einziger Widerstandswert und ein Kapazitätswert zwischen dem Netz und der Antenne gemessen. Die Induktivität der Netze ist so gering, daß sie vernachlässigt werden kann.

Die Meßfinger 4 werden so angesteuert, daß in einem Segment eine einzige Elektrode 1 mit einer Antenne bzw. einer Antennenkombination in Verbindung steht, und die anderen Meßfinger 4 mit ihren Elektroden 1 die zu vermessenden Prüfpunkte 2 abtasten, so daß mit einer dritten Auswerteeinrichtung 12 die Kapazitäten $C_k$ bzw. der Imaginärteil des Leitwertes $Y_{kl}$ zwischen der Antenne A und dem zu messenden Netz $N_k$ an dem jeweiligen Prüfpunkt 2 aufgenommen wird. Mit der zweiten Auswerteeinrichtung 11 wird der Widerstand bzw. der Realteil $Y_{kR}$ zwischen der Antenne A und dem zu messenden Netz $N_k$ erfaßt.

Bei großen Netzen wird somit bei einem weiteren Meßvorgang eine Sonde 1 permanent mit einer Antenne kontaktiert, und alle Prüfpunkte 2 werden jeweils ein einziges mal mit einer Sonde 1 zur Aufnahme des Leitwertes kontaktiert.

Bei kleineren Netzen, die die Ungleichung (17) nicht erfüllen, wird zuerst eine Leitwertmessung zwischen der Antenne A und dem Netz $N_k$ ausgeführt, wozu eine Sonde 1 mit einer Antenne und eine weitere Sonde 1 mit einem Prüfpunkt 2 des Netzes kontaktiert werden. Zur Feststellung von Unterbrechungen werden alle Prüfpunkte paarweise mit zwei Sonden 1 kontaktiert.

Die zweite und dritte Auswerteeinrichtung 11, 12 zum Wahrnehmen eines Widerstandes bzw. einer Kapazität beruhen im Gegensatz zur ersten Auswerteeinrichtung 10, die mit einer Spannungsmessung die Feldwerte aufnimmt, auf einer Strommessung. Durch das Vorsehen der drei Auswerteeinrichtungen 10, 11, 12 in einer Meßvorrichtung ist es möglich, das erfindungsgemäße Verfahren, das sowohl auf einer Feldmessung als auch auf einer Leitwertmessung beruht, durchzuführen.

Ein Multi-Finger-System, dessen zentrale Steuereinheit 8 zur Ausführung der erfindungsgemäßen Verfahren ausgebildet ist, muß im Vergleich zu bekannten Multi-Finger-Systemen eine viel geringere Anzahl von Bewegungen der Meßfinger 4 beim Vermessen gleicher Leiteranordnungen ausführen, da Kurzschlüsse mit einer einzigen Leitwertmessung pro Netz, und bei größeren Netzen Unterbrechungen mit einer Leitwertmessung pro Prüfpunkt detektiert werden können. Die durch die Erfindung erzielten Verbesserungen beruhen u.a. darauf, daß die Leitwerte und nicht wie im Stand der Technik deren Kehrwerte, die Impedanzen, untersucht werden, wodurch die darin enthaltenen Informationen effektiver ausgewertet werden können.

**Patentansprüche**

1. Verfahren zur Prüfung einer elektrischen Leiteranordnung mit einer Vielzahl von Netzen, das in einen ersten Meßvorgang und in weitere Meßvorgänge unterteilt ist, wobei bei jedem Meßvorgang eine Leiteranordnung geprüft wird, und
beim ersten Meßvorgang eine Feldmessung zur Ermittlung von Kurzschlüssen zwischen den einzelnen Netzen und eine Widerstandsmessung zur Ermittlung von Unterbrechungen in den Netzen ausgeführt werden, wobei bei der Feldmessung an die zu messenden Netze unterschiedliche elektrische Felder angelegt werden und die hierdurch an den zu messenden Netzen erzeugten Potentiale gemessen werden und alle Potentialwerte eines Netzes einen Datensatz bilden, und aus diesen Datensätzen komplexe Leitwerte zwischen zumindest einer bei der Feldmessung verwendeten Antenne ($A_i$) und den gemessenen Netzen, $N_k$, bestimmt werden, die als Referenzleitwerte für die weiteren Meßvorgänge verwendet werden, und wobei, falls wegen Fehlern in der im ersten Meßvorgang gemessenen Leiteranordnung nicht für alle Netze Referenzleitwerte ermittelt werden konnten, der erste Meßvorgang mit weiteren Leiteranordnungen so oft wiederholt wird, bis für alle Netze Referenzleitwerte ermittelt sind, und bei den weiteren Meßvorgängen Kurzschlüsse zwischen den Netzen und/oder Unterbrechungen in den Netzen durch Messen eines komplexen Ist-Leitwerts zwischen jedem Netz und der zumindest einen Antenne und durch einen Vergleich des Ist-Leitwertes mit dem Referenzleitweri ermittelt werden.

2. Verfahren nach Anspruch 1,
**dadurch gekennzeichnet,**
**daß** während des ersten Meßvorgangs aus den sich bei der Feldmessung ergebenden Datensätzen die komplexen Leitwerte ermittelt und als Referenzwerte abgespeichert werden.

3. Verfahren nach Anspruch 1 oder 2,
**dadurch gekennzeichnet,**
**daß** die einen Real- und Imaginärteil aufweisenden komplexen Leitwerte nur als Referenzwerte verwendet werden, wenn der Realteil gleich Null ist, wobei dann als Referenzwert der Imaginärteil des Leitwertes abgespeichert wird, der der Kapazität zwischen der Antenne und dem Netz entspricht.

4. Verfahren nach einem der Ansprüche 1 bis 3,
**dadurch gekennzeichnet,**
**daß** bei der Feldmessung mehrere Antennen $A_1$ bis $A_n$ verwendet werden, wobei beim Vermessen eines Netzes (N) an die Antennen ($A_1$ bis $A_n$), und zwar aufeinanderfolgend jeweils an eine dieser Antennen ($A_i$) eine Eingangsspannung $U_0$ angelegt wird, während die übrigen Antennen mit Masse verbunden sind und an dem Netz N jeweils eine Spannung $U_i$ abgegriffen wird.

**5.** Verfahren nach einem der Ansprüche 1 bis 4,
**dadurch gekennzeichnet,**
**daß** die Eingangsspannung $U_0$ vorzugsweise eine Sinuswelle mit einer bestimmten Frequenz, bspw. $2\pi\omega = 2$ kHz, ist, wobei die Amplitude im Bereich von 4 V bis 250 V liegt.

**6.** Verfahren nach Anspruch 4 oder 5,
**dadurch gekennzeichnet,**
**daß** der Referenzleitwert $Y_i = Y_{iR} + iY_{ii}$ aus der bei der Feldmessung an die Antenne $A_i$ angelegten Eingangsspannung $U_0$, deren Kreisfrequenz $\omega$, den Spannungswerten $U_i = U_{iR} + U_{il}$ und einer Sondenkapazität $C_p$ mit folgenden Formeln berechnet wird:

$$Y_{il} = \frac{U_{iR} * X_I + U_{il} * Y_R}{U_0}$$

$$Y_{iR} = \frac{U_{iR} * Y_R - U_{il} * X_I}{U_0}$$

wobei

$$X_i = Y_i + \omega * C_p$$

und der Realteil und der Imaginärteil des Gesamtleitwertes $Y = Y_R + iY_I$ sich folgendermaßen bestimmen

$$Y_I = \frac{\sum U_{iR} * (U_0 - \sum U_{iR}) - (\sum U_{il})^2}{(U_0 - \sum U_{iR})^2 + (\sum U_{il})^2} * \omega * C_p$$

$$Y_R = \frac{-U_0 - \sum U_{il}}{(U_0 - \sum U_{iR})^2 + (\sum U_{il})^2} * \omega * C_p$$

wobei die Summenzeichen jeweils eine Summe von 1 bis n über die Anzahl n der verwendeten Antennen darstellen.

**7.** Verfahren nach einem der Ansprüche 4 bis 6,
**dadurch gekennzeichnet,**
**daß** als Antennen $A_1$ bis $A_n$ Netze der Leiteranordnung verwendet werden.

**8.** Verfahren nach einem der Ansprüche 4 bis 6,
**dadurch gekennzeichnet,**
**daß** als Antennen $A_1$ bis $A_n$ getrennt von der Leiteranordnung ausgebildete Leiterbahnen verwendet werden, die vorzugsweise direkt auf die Leiteranordnung aufgelegt werden können.

**9.** Verfahren nach einem der Ansprüche 4 bis 6,
**dadurch gekennzeichnet,**
**daß** die zu vermessenden Netze (N) der Leiteranordnung als Antennen verwendet werden und an gegenüber von der Leiteranordnung getrennt ausgebildeten Leiterbahnen die Spannungen $U_i$ abgegriffen werden.

**10.** Verfahren nach einem der Ansprüche 1 bis 9,
**dadurch gekennzeichnet,**
**daß**, wenn mehr als die vorbestimmte Anzahl g von Netzen beim ersten Meßvorgang defekt sind, mit einer weiteren Leiteranordnung die Feldmessung wiederholt wird, wobei die fehlenden Referenzwerte durch die neuen Messungen an nicht defekten Netzen ergänzt werden, und,

**daß**, wenn weniger als die vorbestimmte Anzahl von Netzen defekt sind, ein weiterer Meßvorgang ausgeführt wird, bei dem der komplexe Leitwert, $Y_k$, gemessen wird, wobei durch einen Vergleich des Leitwertes des beim ersten Meßvorgang defekten Netzes mit den Leitwerten der übrigen Netze und einer eventuell auszuführenden Widerstandsmessung zwischen Netzen mit gleichem Leitwert festgestellt wird, ob am gleichen Netz wiederum ein Defekt vorliegt, und, wenn dies nicht der Fall sein sollte, der gemessene Leitwert, $Y_k$, als Referenzwert abgespeichert wird.

**11.** Verfahren nach einem der Ansprüche 1 bis 10,
**dadurch gekennzeichnet,**
**daß** aus den sich bei der Feldmessung ergebenden Datensätzen ein komplexer Gesamtleitwert, $Y_{kG}$, zwischen mehreren der bei der Feldmessung verwendeten Antennen ($A_i$) und einem der gemessenen Netze, $N_k$, ermittelt wird, und
die Antennen ($A_i$), die dem Gesamtleitwert $Y_{kG}$ zugrunde liegen, bei den weiteren Meßvorgängen zu einer einzigen Antenne elektrisch verbunden werden.

**12.** Verfahren nach einem der Ansprüche 1 bis 11,
**dadurch gekennzeichnet,**
**daß** beim Vergleich des ist-Leitwertes und des Referenzleitwertes nur die in den Leitwerten enthaltenen Kapazitäten in an sich bekannter Weise miteinander verglichen werden.

**13.** Verfahren nach einem der Ansprüche 1 bis 12, wobei Datensätze der komplexen Leitwerte zwischen zumindest einer Antenne ($A_i$) und den zu messenden Netzen, $N_k$, als Referenzleitwerte, $C_{ka}$, abgespeichert sind,
wobei zur Ermittlung von Kurzschlüssen zwischen den Netzen eine Messung des Ist-Leitwertes, $Y_k=Y_{kR}+iY_{kl}$, zwischen der Antenne ($A_i$) und dem zu vermessenden Netz, $N_k$, durchgeführt wird, und die Ermittlung der Kurzschlüsse durch einen Vergleich erfolgt, bei dem der Realteil, $Y_{kR}$, des Ist-Leitwertes mit Null und der Imaginärteil, $Y_{kl}$, mit dem entsprechenden Referenzleitwert verglichen wird.

**14.** Verfahren nach Anspruch 13,
**dadurch gekennzeichnet,**
**daß** der Vergleich auf folgender Ungleichung beruht

$$(abs(Y_{kR})+\Delta_Y)^2+(abs(Y_{kl}-\omega{}^*C_{ka})+\Delta_Y+\Delta_c)^2\leq\frac{1}{R_{TK}^2+(\frac{1}{\omega{}^*C_{ka}})^2}$$

und ein Kurzschluß vorliegt, wenn die Ungleichung nicht erfüllt ist, wobei $\Delta_Y$ die Meßabweichung für den gemessenen Leitwert, $Y_k$, und $\Delta_c$ die maximale Abweichung zwischen den Kapazitäten der gleichen Netze unterschiedlicher Leiteranordnungen und $R_{TK}$ ein Schwellenwert ist.

**15.** Verfahren nach Anspruch 13 oder 14,
**dadurch gekennzeichnet,**
**daß**, wenn ein Kurzschluß festgestellt wird, eine Widerstandsmessung durchgeführt wird, um den Kurzschluß zu lokalisieren.

**16.** Verfahren nach einem der Ansprüche 1 bis 15, wobei Datensätze der komplexen Leitwerte zwischen zumindest einer Antenne ($A_i$) und den zu messenden Netzen, $N_k$, als Referenzleitwerte, $C_{ka}$, abgespeichert sind,
wobei zur Ermittlung von Unterbrechungen in den Netzen eine Leitwertmessung des Ist-Leitwertes, $Y_k=Y_{kR}+iY_{kl}$, zwischen der Antenne ($A_i$) und dem zu vermessenden Netz, $N_k$, durchgeführt wird, und die Ermittlung der Unterbrechungen durch einen Vergleich mit dem entsprechenden Referenzleitwert erfolgt, bei dem auch der Realteil, $Y_{kR}$, des Ist-Leitwertes einfließt.

**17.** Verfahren nach Anspruch 16,
**dadurch gekennzeichnet,**
**daß** der Vergleich auf folgenden Ungleichungen beruht

$$\omega^* C - Y_{kl} + \Delta_Y + \Delta_C < \frac{\omega^* C}{4}$$

$$Y_{kR} + \Delta_Y < \frac{R_{TU}^* \omega^2 {}^* C^2}{8}$$

und keine Unterbrechung vorliegt, wenn beide Ungleichungen erfüllt sind, wobei $\Delta_Y$ die Meßabweichung für den gemessenen Leitwert, $Y_k$, und $\Delta_C$ die maximale Abweichung zwischen den Kapazitäten der gleichen Netze unterschiedlicher Leiteranordnungen und $R_{TU}$ ein Schwellenwert ist.

18. Verfahren nach Anspruch 16 oder 17,
**dadurch gekennzeichnet,**
**daß** der Vergleich der Leitwerte zur Ermittlung von Unterbrechungen nur an Netzen durchgeführt wird, die folgender Ungleichung genügen

$$C > \frac{4^* \delta}{\omega^* R_{TU}},$$

wobei $\delta = \Delta Y / Y$ die Genauigkeit der Leitwertmessung und C die als Referenzwert abgespeicherte Kapazität des Netzes, $N_k$, ist.

19. Verfahren nach Anspruch 18,
**dadurch gekennzeichnet,**
**daß** an Netzen, an welchen Unterbrechungen nicht durch einen Leitwertvergleich ermittelt werden, die Unterbrechungen durch eine an sich bekannte Widerstandsmessung ermittelt werden.

20. Vorrichtung zum Ausführen eines Verfahrens nach den Ansprüchen 1 bis 19, mit
Elektroden (1), die mit vorbestimmten Prüfpunkten (2) an Netzen einer Leiteranordnung kontaktiert werden können,
einem Funktionsgenerator (9) zum Abgeben einer Eingangsspannung ($U_0$) an eine Antenne ($A_i$),
einer ersten Auswerteeinrichtung (10) zum Ausführen einer Feldmessung, wobei eine Spannung, $U_i$, an dem zu messenden Netz, $N_k$, abgegriffen wird, und
einer zweiten Auswerteeinrichtung (11) zum Ausführen einer Widerstandsmessung zwischen dem Netz und der Antenne und zum Ausführen einer Widerstandsmessung zwischen Prüfpunkten von einzelnen Netzen,
**dadurch gekennzeichnet,**
**daß** die Vorrichtung eine dritte Auswerteeinrichtung (12) zum Ausführen einer Kapazitätsmessung zwischen dem Netz und der Antenne aufweist, so daß aus dem ermittelten Widerstandswert und dem ermittelten Kapazitätswert der komplexe Leitwert, $Y_k$, zwischen dem Netz und der Antenne gebildet werden kann.

21. Vorrichtung nach Anspruch 20,
**gekennzeichnet durch**
mehrere Meßfinger (4), in die jeweils eine Elektrode (1) integriert ist, und die mittels einer Positioniereinrichtung (5) entlang einer Leiteranordnung (3) verfahren werden können, und
eine zentrale Steuereinheit (8), die die Positioniereinrichtung (5), den Funktionsgenerator (9) und die drei Auswerteeinrichtungen (10, 11, 12) so steuert,
daß in einem ersten Meßvorgang eine Feldmessung ausgeführt wird, um Kurzschlüsse zwischen den zu vermessenden Netzen in der Leiteranordnung festzustellen, und
die erste Auswerteeinrichtung (18) aufgrund der bei der Feldmessung ermittelten Datensätze die komplexen Leitwerte zwischen den gemessenen Netzen und den jeweiligen Antennen ermittelt, die als Referenzleitwerte abgespeichert werden, so daß die weiteren Meßvorgänge zur Ermittlung von Kurzschlüssen und/oder Unterbrechungen **durch** Vergleich eines gemessenen komplexen Ist-Leitwertes mit einem komplexen Referenzleitwert ausgeführt werden können.

22. Vorrichtung nach Anspruch 21,
**dadurch gekennzeichnet,**
**daß** die Vorrichtung vorzugsweise acht oder mehr Meßfinger (4), aufweist, wobei die Meßfinger (4) vorzugsweise auf beiden Seiten der Leiteranordnung (3) anzuordnen sind.

**23.** Vorrichtung nach einem der Ansprüche 19 bis 22,
**dadurch gekennzeichnet,**
**daß** die zentrale Steuereinheit (8) so ausgebildet ist,
**daß** bei dem in den weiteren Meßvorgängen durchgeführten Vergleich zwischen dem komplexen Ist-Leitwert und dem komplexen Referenzleitwert der Realteil des Ist-Leitwertes mit berücksichtigt wird.

**Claims**

**1.** A method of testing an electrical conductor assembly having a plurality of networks which is divided into a first test routine and further test routines, whereby a conductor assembly is tested in each test routine, and in a first test routine a field test for detecting short-circuits between the individual networks and a resistance test for detecting open circuits in said networks are implemented, wherein in the field test different electrical fields are applied to the networks to be tested, and the potentials generated by this in the networks to be tested are measured, and all potential values form a data set, and from the data sets resulting from said field test complex conductances are determined between at least one antenna ($A_i$) employed in said field test and the tested networks (Nk) which are used as reference conductances for the further test routines, and wherein if due to faults in the conductor assembly measured in the first test routine it was not possible to determine reference conductances for all networks, the first test routine is repeated with further conductor assemblies until reference conductances have been obtained for all networks, and in further test routines short-circuits between said networks and/or open circuits in said networks are detected by sensing a complex actual conductance between each network and at least one antenna and by comparing said actual conductance to said reference conductance.

**2.** The method as set forth in claim 1,
**characterised in that**,
during said first test routine the complex conductances are established from said data sets resulting from said field test and memorized as reference values.

**3.** The method as set forth in claim 1 or 2,
**characterised in that**,
said complex conductances comprising a real portion and an imaginary portion are only employed as reference values when said real portion equals zero, the imaginary portion of said conductance then being memorized as the reference value, corresponding to the capacitance between said antenna and said network.

**4.** The method as set forth any of claims 1 to 3,
**characterised in that**,
in the field test several antennas $A_1$ to $A_n$ are employed, wherein during testing of a network N an input voltage $U_o$ is applied to the antennas ($A_1$ to $A_n$), and specifically to each of the antennas ($A_1$ to $A_n$) of in sequence, whilst the remaining antennas are connected to GND and one voltage $U_i$ each is sensed at said network N.

**5.** The method as set forth in any of claims 1 to 4,
**characterised in that**
said input voltage $U_0$ is preferably a sine wave having a specific frequency, e.g. $2\pi\omega = 2$ kHz, the amplitude being in the range 4 V to 250 V.

**6.** The method as set forth in claim 4 or 5,
**characterised in that**
said reference conductance $Y_i = Y_{iR} + iY_{il}$ is computed from said input voltage $U_0$ applied to said antenna $A_i$ in the field test, the angular frequency $\omega$, the voltage values $U_i = U_{iR} + U_{il}$ and a probe capacitance $C_p$ of which are computed by the following equations:

$$Y_{il} = \frac{U_{iR} * X_l + U_{il} * Y_R}{U_0}$$

$$Y_{iR}=\frac{U_{iR}*Y_R-U_{il}*X_I}{U_0}$$

where

$$X_i=Y_i+\omega*C_p$$

and said real portion and said imaginary portion of said total conductance $Y=Y_R+iY_I$ are determined as follows

$$Y_I=\frac{\sum U_{iR}*(U_0-\sum U_{iR})-(\sum U_{il})^2}{(U_0-\sum U_{iR})^2+(\sum U_{il})^2}*\omega*C_p$$

$$Y_R=\frac{-U_0*\sum U_{il}}{(U_0-\sum U_{iR})^2+(\sum U_{il})^2}*\omega*C_p$$

where the sum symbols each represent a sum of 1 to n over the number n of antennas employed.

7. The method as set forth in any of claims 4 to 6,
   **characterised in that**
   networks of the conductor assembly are employed as said antennas $A_1$ to $A_n$.

8. The method as set forth in any of claims 4 to 6,
   **characterised in that**
   conductance paths configured separate from said conductor assembly are employed as said antennas $A_1$ to $A_n$ which may be preferably placed directly on said conductor assembly.

9. The method as set forth in any of claims 4 to 6,
   **characterised in that**
   said networks (N) of said conductor assembly to be tested are employed as antennas and voltages $U_i$ are sensed at conductance paths configured separately relative to said conductor assembly.

10. The method as set forth in any of claims 1 to 9,
    **characterised in that**,
    if more than the predetermined number of networks g are defective in the first test routine, then the field test is repeated with a further conductor assembly, the missing reference values being supplemented by the new test results on non-defective networks, and
    if less than the predetermined number of networks g are defective, then a further test routine is implemented in which the complex conductance, $Y_k$, is obtained, it being established by comparing the conductance of said network found to be defective in said first test routine to the conductances of the remaining networks, and a resistance test to be implemented if necessary between networks having the same conductance, whether a defect in turn exists in the same network and, should this not be the case, then said sensed conductance, Yk, is memorized as the reference value.

11. The method as set forth in any of claims 1 to 10,
    **characterised in that**
    a complex total conductance, $Y_{kG}$, between several antennas ($A_i$) employed in said field test and one of said networks $N_k$ tested is established from the data sets resulting from said field test, and
    said antennas ($A_i$) forming the basis of said total conductance $Y_{kG}$ are electrically connected to a single antenna in the further test routines.

12. The method as set forth in any of claims 1 to 11,
    **characterised in that**,
    in comparing said actual conductance and said reference conductance only the capacitances contained in said conductances are compared to each other by ways and means known as such.

**13.** A method according to any of claims 1 to 12, wherein data sets of complex conductances between at least one antenna ($A_i$) and said networks, Nk, to be tested are memorized as reference conductances, $C_{ka}$, said detection of short-circuits between said networks being implemented by sensing said actual conductance, $Y_k=Y_{kR}+iY_{kI}$, between said antenna ($A_i$) and said network, $N_k$, to be tested and said sensing of short-circuits resulting from a comparison in which also said real portion, $Y_{kR}$, of said actual conductance is compared with zero and the imaginary portion, $Y_{ki}$, is compared with the corresponding reference conductance.

**14.** The method as set forth in claim 13
**characterised in that**,
said comparison is based on the following inequality

$$(abs(Y_{kR})+\Delta_Y)^2+(abs(Y_{kl}-\omega^*C_{ka})+\Delta_Y+\Delta_c)^2 \leq \frac{1}{R_{TK}^2+(\frac{1}{\omega^*C_{ka}})^2}$$

and a short-circuit exists when said inequality is not satisfied, where $\Delta_Y$ is the deviation in the result for the sensed conductance, $Y_k$, and $\Delta_c$ is the maximum deviation between said capacitances of the same networks of differing conductor assemblies and $R_{TK}$ is a threshold value.

**15.** The method as set forth in claim 13 or 14
**characterised in that**,
when a short-circuit is sensed a resistance test is implemented to pin-point said short-circuit.

**16.** A method according to any of claims 1 to 15, whereby said data sets of the said complex conductances between at least one antenna ($A_i$) and said networks, $N_k$, to be tested are memorized as reference conductances ($C_{ka}$), said detection of open-circuits between said networks being implemented by sensing said actual conductance, $Y_k=Y_{kR}+iY_{kI}$, between said antenna ($A_i$) and said network, $N_k$, to be tested and said sensing of short-circuits resulting from a comparison with the corresponding reference conductance, in which also said real portion, $Y_{kR}$, of said actual conductance is involved.

**17.** The method as set forth in claim 16
**characterised in that**
said comparison is based on the following inequalities

$$\omega^*C-Y_{kl}+\Delta_Y+\Delta_C < \frac{\omega^*C}{4}$$

$$Y_{kR}+\Delta_Y < \frac{R_{TU}^*\omega^*C^2}{8}$$

and no open-circuit exists when both inequalities are satisfied, where $\Delta_Y$ is the deviation in the result for the sensed conductance, $Y_k$, and $\Delta_c$ is the maximum deviation between said capacitances of the same networks of differing conductor assemblies and RTU is a threshold value.

**18.** The method as set forth in claim 16 or 17
**characterised in that**
said comparison of said conductances for detecting open-circuits is implemented only on networks satisfying the following inequality

$$C_k > \frac{4^*\delta}{\omega^*R_{TU}},$$

where $\delta=\Delta Y/Y$ is the accuracy of the conductance test and C is the capacitance of said network, $N_k$, memorized as said reference value.

**19.** The method as set forth in claim 18
**characterised in that**,
in networks in which open-circuits are not detected by a conductance comparison, said open-circuits are detected by a resistance test known as such.

**20.** An apparatus for implementing a method as set forth in any
of the claims 1 to 19,
comprising
electrodes (1) which can be brought into contact with predetermined test points (2) on said networks of said conductor assembly,
a function generator (9) for outputting an input voltage ($U_0$) to an antenna ($A_i$),
a first evaluation means (10) for implementing a field test, a voltage, $U_i$, being sensed at said network, $N_k$, to be tested, and
a second evaluation means (11) for implementing a resistance test between said network and said antenna, and for implementing a resistance test between test points of individual networks
**characterised in that**
said apparatus comprises a third evaluation means (12) for implementing a capacitance test between said network and said antenna, so that from the detected resistance value and the detected capacitance value the complex conductance, $Y_k$, between said network and said antenna can be formed.

**21.** The apparatus as set forth in claim 20
**characterised by**
several test fingers (4) in each of which an electrode (1) is integrated and which can be moved by a positioning means (5) along a conductor assembly (3) and
a central control unit (8) which controls said positioning means (5), said function generator (9) and said three evaluations means (10, 11, 12) such that
in a first test routine a field test is implemented, to detect short-circuits between said networks to be tested in said conductor assembly and
said first evaluation means (18) as a result of said data sets established in said field test detects said complex conductances between said tested networks and each of said antennas, which are memorized as reference conductances, so that the further test routines for detecting short-circuits and/or open-circuits can be implemented by comparing a detected complex actual conductance to a complex reference conductance.

**22.** The apparatus as set forth in claim 21
**characterised in that**
said apparatus comprises preferably eight or more test fingers (4), wherein the test fingers (4) are preferably to be arranged on both sides of the conductor assembly (3).

**23.** The apparatus as set forth in claims 19 to 22
**characterised in that**
said central control unit (8) is configured such that in the comparison between said complex actual conductance and said complex reference conductance implemented in said further test routines the real portion of said actual conductance is taken into account.

**Revendications**

**1.** Procédé de test d'une structure de conducteurs électriques comportant un grand nombre de réseaux, qui est subdivisé en un premier processus de mesure et en d'autres processus de mesures,
dans lequel une structure de conducteurs est testée lors de chaque processus de mesure et il est réalisé, lors du premier processus de mesure, une mesure de champ en vue de déterminer des courts-circuits entre les réseaux individuels et une mesure de résistance en vue de déterminer des coupures dans le réseau,
dans lequel différents champs électriques sont appliqués aux réseaux à mesurer lors de la mesure de champ et les potentiels ainsi générés au niveau des réseaux à mesurer sont mesurés et tous les valeurs de potentiel d'un réseau forment un ensemble de données à partir duquel il est déterminé entre au moins une antenne ($A_i$) utilisée lors de la mesure de champ et les réseaux mesurés, $N_k$, des valeurs de conduction complexes qui sont utilisées pour les comme valeurs de conduction de référence pour les autres processus de mesure, et
dans lequel, dans le cas où les valeurs de conduction de référence n'ont pas pu être déterminées pour tous les réseaux en raison d'erreurs dans la structure de conducteurs mesurée lors du processus de mesure, le premier processus de mesure est répété avec d'autres structures de conducteurs jusqu'à ce que des valeurs de conduction de référence soient déterminées pour tous les réseaux, et des courts-circuits entre les réseaux et des coupures dans les réseaux sont détectés lors des autres processus de mesure en mesurant une valeur de conduction réelle complexe entre chaque réseau et l'au moins une antenne et en comparant la valeur de conduction réelle avec la valeur de conduction de référence.

2. Procédé selon la revendication 1, **caractérisée en ce que** des valeurs de conduction complexes sont déterminées lors du premier processus de mesure à partir des ensembles de données obtenues lors de la mesure de champ et sont mémorisées en tant que valeurs de référence.

3. Procédé selon l'une des revendications 1 ou 2, **caractérisé en ce que** les valeurs de conduction complexes comportant une partie réelle et une partie imaginaire ne sont utilisées comme valeurs de référence que si la partie réelle est nulle, la partie imaginaire de la valeur de conduction, qui correspond à la capacité entre l'antenne et le réseau, étant alors mémorisée en tant que valeur de référence.

4. Procédé selon l'une des revendications 1 à 3, **caractérisé en ce que** plusieurs antennes $A_1$ à $A_n$ sont utilisées lors de la mesure de champ, une tension d'entrée $U_0$ étant appliquée lors de la mesure d'un réseau (N) aux antennes ($A_1$ à $A_n$), c'est-à-dire à chaque fois à l'une de ces antennes successivement, tandis que les autres antennes sont reliées à la masse et une tension $U_i$ est prélevée à chaque fois sur le réseau N.

5. Procédé selon l'une des revendications 1 à 4, **caractérisé en ce que** la tension d'entrée $U_0$ est de préférence une onde sinusoïdale de fréquence déterminée, par exemple $2\pi\omega = 2$ kHz, l'amplitude étant comprise entre 4 V et 250 V.

6. Procédé selon la revendication 4 ou 5, **caractérisé en ce que** la valeur de conduction de référence $Y_i = Y_{iR} + iY_{il}$ est calculée à partir de la tension d'entrée $U_0$ de pulsation $\omega$ appliquée à l'antenne $A_i$ lors de la mesure de champ, des valeurs de tension $U_i = U_{IR} + iU_{il}$ et d'une capacité de sonde $C_p$ conformément aux formules suivantes :

$$Y_{il} = \frac{U_{iR}{}^*X_I + U_{il}{}^*Y_R}{U_0}$$

$$Y_{iR} = \frac{U_{iR}{}^*X_R - U_{il}{}^*X_I}{U_0}$$

où

$$X_i = Y_I + \omega^*C_p$$

et la partie réelle et la partie imaginaire de la valeur de conduction totale sont déterminées de la manière suivante :

$$Y_I = \frac{\sum U_{iR}{}^*(U_0 - \sum U_{iR}) - (\sum U_{il})^2}{(U_0 - \sum U_{iR})^2 + (\sum U_{il})^2}{}^*\omega^*C_p$$

$$Y_R = \frac{-U_0{}^*\sum U_{il}}{(U_0 - \sum U_{iR})^2 + (\sum U_{il})^2}{}^*\omega^*C_p$$

où les signes Somme représentent à chaque fois une somme de 1 à n, n étant le nombre des antennes utilisées.

7. Procédé selon l'une des revendications 4 à 6, **caractérisé en ce qu'**il est utilisé des réseaux de la structure de conducteurs comme antennes $A_1$ à $A_n$.

8. Procédé selon l'une des revendications 4 à 6, caractérisg en ce qu'il est utilisé comme antennes $A_1$ à $A_n$ des pistes conductrices 5, conformées séparément de la structure de conducteurs, qui peuvent être placées sur la structure de conducteurs.

**9.** Procédé selon l'une des revendications 4 à 6, **caractérisé en ce que** les réseaux (N) à mesurer de la structure de conducteurs sont utilisés comme antennes et les tensions $U_i$ sont appliquées aux pistes conductrices conformées séparément de la structure de conducteurs.

**10.** Procédé selon l'une des revendications 1 à 9, **caractérisé en ce que** la mesure de champ est répétée avec une autre structure de conducteurs si le nombre de réseaux défectueux lors du premier processus de mesure est supérieur à un nombre prédéterminé g, les valeurs de référence erronées étant complétées par les nouvelles mesures effectuées sur des réseaux non défectueux, et **en ce que**, si le nombre de réseaux défectueux est inférieur au nombre prédéterminé, il est réalisé un autre processus de mesure dans lequel on mesure la valeur de conduction complexe, $Y_k$, une comparaison de la valeur de conduction du réseau défectueux lors du premier processus de mesure avec les valeurs de conduction des autres réseaux et une mesure de résistance à réaliser éventuellement entre des réseaux de même valeur de conduction permettant de déterminer s'il existe encore un défaut au niveau du même réseau, et, si ce n'est pas le cas, la valeur de conduction mesurée, $Y_k$, est mémorisée en tant que valeur de référence.

**11.** Procédé selon l'une des revendications 1 à 10, **caractérisé en ce que** l'on détermine à partir des ensembles de données, obtenus lors de la mesure de champ, une valeur de conduction totale complexe, $Y_{kG}$, entre plusieurs des antennes $(A_l)$ utilisées lors de la mesure de champ et l'un des réseaux mesurés, $N_k$, et les antennes $(A_i)$ qui sont à la base de la valeur de conduction totale sont reliées électriquement à une seule antenne lors des autres processus de mesure.

**12.** Procédé selon l'une des revendications 1 à 11, **caractérisé en ce que** seules les capacités contenues dans les valeurs de conduction sont comparées entre elles de façon connue en soi lors de la comparaison de la valeur de conduction réelle avec la valeur de conduction de référence.

**13.** Procédé selon l'une des revendications 1 à 12, dans lequel les ensembles de données des valeurs de conduction complexes entre au moins une antenne $(A_i)$ et les réseaux à mesurer, $N_k$, sont mémorisés en tant que valeur de conduction de référence, $C_{ka}$, une mesure de la valeur de conduction réelle, $Y_k = Y_{kR} + iY_{kI}$, entre l'antenne $(A_i)$ et le réseau à mesurer, $N_k$, étant effectuée en vue de déterminer des courts-circuits entre les réseaux, et la détermination des courts-circuits est effectuée au moyen d'une comparaison dans lequel la partie réelle, $Y_{kR}$, de la valeur de conduction réelle est comparée à zéro et la partie imaginaire, $Y_{kI}$, est comparée à la valeur de conduction de référence correspondante.

**14.** Procédé selon la revendication 13, **caractérisé en ce que** la comparaison repose sur l'inégalité suivante

$$(abs(Y_{kR})+\Delta_Y)^2 + (abs(Y_{kI} - \omega^*C_{ka})+\Delta_Y+\Delta_c)^2 \leq \frac{1}{R_{TK}^2 + (\frac{1}{\omega^*C_{ka}})^2}$$

et il y a un court-circuit lorsque l'inégalité n'est pas remplie, $\Delta_Y$ étant l'écart de mesure pour la valeur de conduction mesurée, $Y_k$, et $\Delta_c$ étant l'écart maximum entre les capacités des mêmes réseaux de structures de conducteurs différentes et $R_{TK}$ étant une valeur de seuil.

**15.** Procédé selon la revendication 13 ou 14, **caractérisé en ce que**, lorsqu'il est déterminé un court-circuit, il est effectué une mesure de résistance pour localiser le court-circuit.

**16.** Procédé selon l'une des revendications 1 à 15, dans lequel les ensembles de données des valeurs de conduction complexes entre au moins une antenne $(A_l)$ et le réseau à mesurer, $N_k$, sont mémorisés en tant que valeur de conduction de référence, $C_{ka}$, et dans lequel il est effectué une mesure de la valeur de conduction réelle, $Y_k = Y_{kR} + iY_{kI}$, entre l'antenne $(A_l)$ et le réseau à mesurer, $N_k$, en vue de détecter des coupures dans les réseaux et la détection des coupures est effectuée par une comparaison avec la valeur de conduction de référence correspondante, dans laquelle là partie réelle, $Y_{kR}$, de la valeur de conduction réelle est également introduite.

**17.** Procédé selon la revendication 16, **caractérisé en ce que** la comparaison repose sur les inégalités suivantes

$$\omega^* C - Y_{kl} + \Delta_Y + \Delta_C < \frac{\omega^* C}{4}$$

$$Y_{kR} + \Delta_Y < \frac{R_{TU}^* \omega^* C^2}{8}$$

et il n'y a aucune coupure lorsque les deux inégalités sont remplies, $\Delta_Y$ étant l'écart de mesure pour la valeur de conduction mesurée, $Y_k$, et $\Delta_C$ étant l'écart maximum entre les capacités des mêmes réseaux de structures de conducteurs différentes et $R_{TU}$ étant une valeur de seuil.

**18.** Procédé selon la revendication 16 ou 17, **caractérisé en ce que** la comparaison des valeurs de conduction est effectuée en vue de déterminer des coupures seulement au niveau de réseaux qui satisfont l'inégalité suivante

$$C > \frac{4^* \delta}{\omega^* R_{TU}},$$

où $\delta = \Delta Y / Y$ est la précision de la mesure de valeur de conduction et C est la capacité du réseau, $N_k$, mémorisée en tant que valeur de référence.

**19.** Procédé selon la revendication 18, **caractérisé en ce que** les coupures sont détectées par une mesure de résistance connue en soi au niveau de réseaux où des coupures n'ont pas été détectées par une comparaison de valeurs de conduction.

**20.** Dispositif de mise en oeuvre d'un procédé selon les revendications 1 à 19, comportant
des électrodes (1) qui peuvent être mises en contact avec des points de test prédéterminés (2) au niveau de réseaux d'une structure de conducteurs,
un générateur de fonctions (9) destiné à appliquer une tension d'entrée ($U_0$) à une antenne($A_i$),
un premier dispositif d'exploitation (10) destiné à effectuer une mesure de champ, une tension $U_i$ étant appliquée au réseau à mesurer, $N_k$, et
un deuxième dispositif d'exploitation (11) destiné à effectuer une mesure de résistance entre le réseau et l'antenne et à effectuer une mesure de résistance entre des points de test de réseaux distincts,
**caractérisé en ce que** le dispositif comporte un troisième dispositif d'exploitation (12) destiné à effectuer une mesure de capacité entre le réseau et l'antenne de sorte que la valeur de conduction complexe, $Y_k$, entre le réseau et l'antenne peut être obtenue à partir de la valeur de résistance déterminée et de la valeur de capacité déterminée.

**21.** Dispositif selon la revendication 20, **caractérisé par**
plusieurs doigts de mesure (4) dans chacun desquels est intégrée une électrode (1), et qui peuvent être déplacés au moyen d'un dispositif de positionnement (5) le long d'une structure de conducteurs (3), et
une unité de commande centrale (8) qui commande le dispositif de positionnement (5), le générateur de fonctions (9) et les trois dispositifs d'exploitation (10, 11, 12) de sorte qu'une mesure de champ est effectuée lors d'un premier processus de mesure en vue de déterminer des courts-circuits entre les réseaux à mesurer dans la structure de conducteurs, et que le premier dispositif d'exploitation (18) détecte en raison de l'ensemble de données déterminés lors de la mesure de champ les valeurs de conduction complexes entre les réseaux mesurés et les antennes correspondantes, lesquelles sont mémorisées en tant que valeurs de conduction de référence, de sorte que les autres processus de mesure peuvent être mis en oeuvre en vue de détecter des courts-circuits et/ou des coupures en comparant une valeur de conduction réelle complexe avec une valeur de conduction de référence complexe.

**22.** Dispositif selon la revendication 21, **caractérisé en ce que** le dispositif comporte de préférence huit doigts de mesure (4) ou plus, les doigts de mesure (4) étant agencés de préférence des deux côtés de la structure de conducteurs (3).

**23.** Dispositif selon l'une des revendications 19 à 22, **caractérisé en ce que** l'unité de commande centrale (8) est conformée de telle sorte que la partie réelle de la valeur de conduction réelle est prise en compte lors de la comparaison, effectuée lors des autres processus de mesure, de la valeur de conduction réelle complexe avec la valeur de conduction de référence complexe.

Fig. 1

Fig.2

Fig. 3

Fig. 4